# EUROPÄISCHE PATENTSCHRIFT

(11) **EP 3 206 239 B1**
(45) Veröffentlichungstag und Bekanntmachung des Hinweises auf die Patenterteilung: **30.06.2021**
(21) Anmeldenummer: 17157898.2
(22) Anmeldetag: 27.08.2008
(51) Int. Cl.: H01S 5/20, H01S 5/22, H01L 33/44

(54) **STRAHLUNG EMITTIERENDER HALBLEITERCHIP**
RADIATION-EMITTING SEMICONDUCTOR CHIP
PUCE SEMI-CONDUCTRICE ÉMETTANT UN RAYONNEMENT

(30) Priorität: 28.09.2007 DE 102007046497; 14.12.2007 DE 102007060204
(43) Veröffentlichungstag der Anmeldung: 16.08.2017
(62) Teilanmeldung aus: 08834637.4
(73) Patentinhaber: OSRAM Opto Semiconductors GmbH, 93055 Regensburg (DE)
(72) Erfinder: LELL, Alfred, 93142 Maxhütte - Haidhof (DE); EICHLER, Christoph, 93093 Donaustauf (DE); RUMBOLZ, Christian, 93138 Lappersdorf (DE)
(74) Vertreter: Epping - Hermann - Fischer

(56) Entgegenhaltungen:
- EP-A- 0 180 222
- EP-B1- 1 012 933
- WO-A-2006/096767
- DE-A1-102006 017 573
- JP-A- 10 163 525
- JP-A- 2000 106 454
- US-A1- 2006 163 595
- US-A1- 2006 193 353
- REINER WINDISCH ET AL: "40% Efficient Thin-Film Surface-Textured Light-Emitting Diodes by Optimization of Natural Lithography", IEEE TRANSACTIONS ON ELECTRON DEVICES, IEEE SERVICE CENTER, PISACATAWAY, NJ, US, Bd. 47, Nr. 7, 1. Juli 2000 (2000-07-01), XP011017321, ISSN: 0018-9383
- SCHNITZER I ET AL: "30% EXTERNAL QUANTUM EFFICIENCY FROM SURFACE TEXTURED, THIN-FILM LIGHT-EMITTING DIODES", APPLIED PHYSICS LETTERS, AIP, AMERICAN INSTITUTE OF PHYSICS, MELVILLE, NY, Bd. 63, Nr. 16, 18. Oktober 1993 (1993-10-18), Seiten 2174-2176, XP000404433, ISSN: 0003-6951

## Beschreibung

Die Erfindung betrifft einen Strahlung emittierenden Halbleiterchip und ein Verfahren zu dessen Herstellung.

Die DE 10 2006 017 573 A1 offenbart einen optoelektronischen Halbleiterkörper.

Windisch R. et al., IEEE Transactions on Electron Devices, Vol. 47, Nr. 7, Juli 2000, S. 1492-1498 offenbart einen strahlungsemittierenden Halbleiterchip mit Dünnfilmoberflächentextur.

Die US 2006/0193353 A1 offenbart einen Hochleistungs-Einmoden-Halbleiterlaser und die EP 1012933 B1 offenbart eine Laservorrichtung.

Strahlung erzeugende Halbleiterchips enthalten typischerweise Halbleitermaterialien, deren Brechungsindex im Vergleich zu einem umgebenden Medium, beispielsweise Luft, relativ hoch ist. Dies hat zur Folge, dass es bei der Strahlungsauskopplung an einer Grenzfläche zwischen dem Halbleiterchip und dem umgebenden Medium leicht zu Totalreflexionen kommen kann, was zu einer verringerten Lichtausbeute führt.

Eine zu lösende Aufgabe besteht vorliegend darin, einen Strahlung emittierenden Halbleiterchip mit verbesserter Lichtausbeute anzugeben. Diese Aufgabe wird durch einen Strahlung emittierenden Halbleiterchip gemäß Patentanspruch 1 gelöst.

Ferner besteht eine zu lösende Aufgabe darin, ein Herstellungsverfahren für einen derartigen Strahlung emittierenden Halbleiterchip anzugeben. Diese Aufgabe wird durch ein Verfahren gemäß den Patentansprüchen 10 oder 11 gelöst.

Vorteilhafte Weiterbildungen des Strahlung emittierenden Halbleiterchips sind in den abhängigen Patentansprüchen angegeben.

Der vorliegenden Erfindung liegt unter anderem die Idee zugrunde, einen Brechungsindexübergang, der zwischen einem ersten Medium mit einem ersten Brechungsindex und einem zweiten Medium mit einem zweiten Brechungsindex auftritt, mittels der Form, Größe und/oder Dichte von Strukturelementen in gewünschter Weise einzustellen. Durch die entsprechende Einstellung kann anwendungsbezogen ein relativ großer oder relativ kleiner, ein gradueller oder kontinuierlicher Brechungsindexübergang erzeugt werden.

Gemäß einer bevorzugten Variante der Erfindung weist der Strahlung emittierende Halbleiterchip eine aktive Zone zur Erzeugung von Strahlung der Wellenlänge λ sowie einen strukturierten Bereich mit unregelmäßig angeordneten Strukturelementen auf, die ein erstes Material mit einem ersten Brechungsindex n₁ enthalten und die von einem Medium umgeben sind, das ein zweites Material mit einem zweiten Brechungsindex n₂ aufweist. Die Wellenlänge λ bezeichnet vorliegend die Wellenlänge im jeweiligen Medium, in welchem die Strahlung propagiert.

Bei einer vorteilhaften Weiterbildung weisen die Strukturelemente jeweils eine Breite b ≤ 4µm und einen Abstand a ≤ 4µm voneinander auf. Insbesondere können die Strukturelemente jeweils eine Breite b ≤ λ und einen Abstand a ≤ λ voneinander aufweisen.

Vorteilhafterweise muss bei der Strukturierung des Bereichs nicht auf eine regelmäßige Anordnung der Strukturelemente geachtet werden. Beispielsweise kann ein Strukturelement zu jedem unmittelbar benachbarten Strukturelement einen unterschiedlichen Abstand a aufweisen, wobei jedoch der Abstand a höchstens 4µm beträgt. Ferner können die einzelnen Strukturelemente verschiedene Breiten b aufweisen, die jedoch vorzugsweise nicht größer als 4µm sind. Die Breite b bezeichnet vorliegend die längste Abmessung einer Querschnittsfläche des jeweiligen Strukturelements bei halber Höhe h/2. Im Falle einer kreisförmigen Querschnittsfläche entspricht die längste Abmessung der Querschnittsfläche dem Durchmesser. Die Querschnittsfläche ist parallel zu einer Grundfläche des Strukturelements angeordnet. Die Höhe h ist die längste Abmessung des Strukturelements ausgehend von der Grundfläche und senkrecht zur Grundfläche.

Im Rahmen der Erfindung gibt es zwei bevorzugte Wertebereiche für die Breite b, nämlich b ≤ λ und λ < b ≤ 4µm. Ist b ≤ λ, so "verschwimmen" die Strukturelemente für eine optische Welle. Ist λ < b ≤ 4µm, so stellen die Strukturelemente Streuzentren für die optische Welle dar.

Gemäß einer vorteilhaften Ausgestaltung kann das Medium die Zwischenräume zwischen den Strukturelementen vollständig ausfüllen. Es ist jedoch auch möglich, dass das Medium Einschlüsse, beispielsweise Lufteinschlüsse aufweist, durch welche ein effektiver Brechungsindex n_{eff} abgesenkt werden kann.

Bei einer weiteren Variante ragen die Strukturelemente aus einer ebenen Oberfläche einer ersten Schicht heraus. Die erste Schicht kann beispielsweise zu einem Stapel epitaktisch gewachsener Halbleiterschichten gehören, aus welchem der Halbleiterchip gebildet ist, oder aber eine auf dem Stapel angeordnete separate Schicht sein. Die Strukturelemente können den gleichen Brechungsindex aufweisen wie die erste Schicht.

Vorzugsweise ist auf der ersten Schicht eine zweite Schicht aufgebracht, die das zweite Material enthält und die Hohlräume zwischen den Strukturelementen ausfüllt. Die zweite Schicht entspricht in diesem Fall dem bereits erwähnten Medium.

Für die folgenden Betrachtungen wird eine Zwischenschicht eingeführt, welche die Strukturelemente und das Medium aufweist und somit das erste und das zweite Material enthält. Die Zwischenschicht enthält also ein Mischmaterial, das heißt eine Mischung aus dem ersten Material und dem zweiten Material. Die Dicke der Zwischenschicht entspricht gemäß der hier verwendeten Definition der Höhe des längsten Strukturelements. Die Strukturelemente weisen eine Breite auf, für die b ≤ λ, bei größeren Wellenlängen auch b ≤ λ/4, gilt. Bei einer derartigen Größe der Strukturelemente nimmt eine optische Welle, welche auf die Zwischenschicht trifft, die Grenze zwischen den Strukturelementen und dem Medium, also die Grenze zwischen dem ersten und dem zweiten Material, nicht mehr wahr, sondern erfährt die Zwischenschicht als homogene Schicht mit einem effektiven Brechungsindex n_{eff}. Da die Zwischenschicht eine Mischung aus dem ersten und dem zweiten Material enthält, liegt der effektive Brechungsindex n_{eff} des Mischmaterials zwischen dem ersten Brechungsindex n₁ und dem zweiten Brechungsindex n₂. Insbesondere gilt für die Zwischenschicht, dass n₂ < n_{eff} < n₁ ist. Es ist jedoch auch möglich, dass n₁ < n_{eff} < n₂ ist.

Vorteilhafterweise ist der effektive Brechungsindex n_{eff} durch die Konzentration des ersten Materials relativ zu der Konzentration des zweiten Materials in der Zwischenschicht eingestellt. Überwiegt die Konzentration des ersten Materials, so resultiert ein effektiver Brechungsindex n_{eff}, der dem ersten Brechungsindex n₁ näher kommt als dem zweiten Brechungsindex n₂. Überwiegt die Konzentration des zweiten Materials, so gilt das umgekehrte.

Zur Erzielung des effektiven Brechungsindizes n_{eff} ist es vorteilhaft, wenn eine Grundflächenbreite g der jeweiligen Strukturelemente kleiner ist als die Höhe h der jeweiligen Strukturelemente. Die Grundflächenbreite g ist vorliegend als die längste Abmessung der Grundfläche des Strukturelements zu verstehen. Bei einer kreisförmigen Grundfläche entspricht die Grundflächenbreite g dem Durchmesser. Insbesondere gilt für das Verhältnis g:h ≤ 1:10.

Nachfolgend werden verschiedene Ausführungsformen eines Halbleiterchips gemäß der vorliegenden Erfindung beschrieben, wobei die verschiedenen Ausführungsformen verschiedene Funktionen des strukturierten Bereichs illustrieren.

Bei einer vorteilhaften Ausführungsform ist der Strahlung emittierende Halbleiterchip ein Laserdiodenchip. Vorteilhafterweise können mittels des strukturierten Bereichs, der an geeigneter Stelle angeordnet ist, im Vergleich zu herkömmlichen Halbleiterlasern höhere Kink-Levels erzielt werden, das heißt, dass höhere Strahlungsleistungen erreicht werden können, ohne dass transversale Modensprünge auftreten.

Insbesondere ist der Laserdiodenchip ein Streifenlaser. Der Streifenlaser kann einen Steg aufweisen, wobei der strukturierte Bereich vorzugsweise an den Flanken des Steges angeordnet ist. An den Flanken kann der strukturierte Bereich vorteilhafterweise zur Modendämpfung verwendet werden.

Der Streifenlaser weist gemäß einem Ausführungsbeispiel einen Steg auf, der bis zur aktiven Zone heranreicht oder sich sogar durch die aktive Zone erstreckt. Dies hat den Vorteil, dass eine relativ geringe Stromaufweitung und damit ein geringer Schwellstrom erzielt werden kann. Bei einem herkömmlichen Laser, der an den Flanken keinen strukturierten Bereich aufweist, tritt jedoch ein relativ starker Brechungsindexsprung zwischen dem Steg und einem umgebenden Medium, typischerweise einem Dielektrikum, auf. Dadurch werden transversale Moden geführt, die die Strahlqualität verschlechtern. Hingegen kann bei dem vorliegenden Ausführungsbeispiel der Brechungsindexsprung mittels des strukturierten Bereichs verringert werden. Insbesondere sind die Strukturelemente mit einer Passivierungsschicht, die den zweiten Brechungsindex n₂ aufweist, überformt. Beispielsweise kann die Passivierungsschicht ein Siliziumoxid enthalten. Die Strukturelemente sind vorzugsweise aus einer Halbleiterschicht des Halbleiterchips gebildet. Die Verringerung des Brechungsindexsprungs hat zur Folge, dass nur noch eine transversale Mode geführt wird. Das Fernfeld des Laserdiodenchips kann also verbessert und der geringe Schwellstrom beibehalten werden. Ferner ist die Passivierungsschicht mittels der Strukturelemente mit der Halbleiterschicht verzahnt, so dass sie besser auf der Halbleiterschicht haftet.

Gemäß einem weiteren Ausführungsbeispiel des Streifenlasers sind die Strukturelemente von einer Absorberschicht überformt. Dadurch kann wiederum der Brechungsindexsprung zwischen der Halbleiterschicht, aus welcher die Strukturelemente vorzugsweise herausgeätzt sind, und der Absorberschicht reduziert werden. Die Eindringtiefe einer optischen Welle kann somit erhöht und die Wechselwirkung der optischen Welle mit der Absorberschicht verbessert werden. Dies hat eine bessere Dämpfung höherer transversaler Moden zur Folge.

Vorzugsweise enthält die Absorberschicht ein Oxid oder Nitrid von Si, Ti, Al, Ga, Nb, Zr, Ta, Hf, Zn, Mg, Rh, In.

Bei einem weiteren Ausführungsbeispiel kann auf der Passivierungsschicht eine Absorberschicht angeordnet sein.

Allen diesen Ausführungsbeispielen ist gemein, dass eine optische Welle aufgrund des verringerten Brechungsindexsprunges, der mittels der überformten Strukturelemente erzielt werden kann, tiefer in die Passivierungsschicht oder die Absorberschicht eindringen kann, wodurch eine bessere Dämpfung höherer Moden erzielt wird.

Bei einer vorteilhaften Ausgestaltung weist der Strahlung emittierende Halbleiterchip ein Laser-Array mit mehreren Streifenlasern und mehreren strukturierten Bereichen auf. Vorzugsweise ist jeweils ein strukturierter Bereich zwischen zwei Streifenlasern angeordnet. Mittels der Strukturelemente kann einerseits, wenn b ≤ λ oder bei größeren Wellenlängen b ≤ λ/4, gilt, ein Brechungsindexübergang zwischen der Schicht, aus welcher die Strukturelemente herausragen, und dem umgebenden Medium reduziert werden und dadurch die Auskopplung von Strahlung verbessert werden. Aber auch wenn λ < b ≤ 4µm ist, kann aufgrund von Streuung an den Strukturelementen das Streulicht besser auskoppeln. Dies hat den Vorteil, dass Streulicht, welches auf benachbarte Streifenlaser übersprechen oder zu Ringmoden führen könnte, besser unterdrückt wird.

Bei einer weiteren Ausführungsform weist der Strahlung emittierende Halbleiterchip einen dielektrischen Spiegel auf. Insbesondere sind die Strukturelemente aus einer ersten Schicht des dielektrischen Spiegels gebildet und von einer zweiten Schicht des dielektrischen Spiegels umgeben. Vorzugsweise enthält die erste Schicht das erste Material mit dem ersten Brechungsindex n₁ und die zweite Schicht das zweite Material mit dem zweiten Brechungsindex n₂. Mittels der überformten Strukturelemente kann eine optische Welle aufgrund des verringerten Brechungsindexsprungs besser in die zweite Schicht eindringen und mit dieser wechselwirken. Vorzugsweise weist die zweite Schicht Einschlüsse auf, insbesondere Lufteinschlüsse, mit einem Brechungsindex, der kleiner ist als der zweite Brechungsindex n₂. Dadurch kann der zweite Brechungsindex n₂ und damit der effektive Brechungsindex n_{eff} abgesenkt werden. Dies hat den Vorteil, dass der Grenzwinkel der Totalreflexion verkleinert ist, so dass ein größerer Strahlungsanteil mittels an dem dielektrischen Spiegel auftretender Totalreflexion in Richtung einer Auskoppelseite des Strahlung emittierenden Halbleiterchips reflektiert werden kann. Die erste und die zweite Schicht können jeweils ein Oxid, Nitrid oder Oxinitrid von Si, Ti, Al, Ga, Nb, Zr, Ta, Hf, Zn, Mg, Rh, In enthalten. Bei einer weiteren Ausführungsform des Strahlung emittierenden Halbleiterchips gemäß der Erfindung ist der strukturierte Bereich in der aktiven Zone angeordnet. Insbesondere bildet der strukturierte Bereich eine Quantentopfstruktur. Die Bezeichnung Quantentopfstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen. Mittels des strukturierten Bereichs kann ein verbesserter Einschluss der Ladungsträger erzielt werden.

Bei einer weiteren Ausgestaltung des Strahlung emittierenden Halbleiterchips ist eine Grundflächenbreite g der jeweiligen Strukturelemente größer als eine Höhe h der jeweiligen Strukturelemente. Insbesondere kann das Verhältnis g:h ≥ 10:1 sein. Insbesondere ist die Breite b der Strukturelemente hierbei λ < b ≤ 4µm.

Bei dieser Ausgestaltung ist der strukturierte Bereich als Auskoppelschicht besonders geeignet.

Bei einer Leuchtdiode ist der strukturierte Bereich vorzugsweise der aktiven Zone in einer Hauptabstrahlrichtung nachgeordnet. Mittels des strukturierten Bereichs, der als Auskoppelschicht dient, kann die Strahlungsauskopplung und damit die Ausgangsleistung verbessert werden.

Ferner kann bei einem Laserdiodenchip, der insbesondere ein Streifenlaser mit einem Steg ist, der strukturierte Bereich als Auskoppelschicht zur Auskopplung von Streulicht dienen. Hierzu ist der strukturierte Bereich vorzugsweise neben dem Steg angeordnet. Das Streulicht propagiert in diesem Fall senkrecht zum Laserlicht und trifft auf den strukturierten Bereich auf, wo es auskoppeln kann. Dadurch kann das Abstrahlverhalten an der Laserfacette verbessert und Superlumineszenz unterdrückt werden.

Bei allen beschriebenen Varianten eines Strahlung emittierenden Halbleiterchips gemäß der Erfindung können die Strukturelemente Kegel oder Polyeder, insbesondere Pyramiden oder Zylinder, sein.

Zur Herstellung des vorausgehend beschriebenen strukturierten Bereichs kommen verschiedene Verfahren in Frage. Allen Verfahren ist gemein, dass eine Maske verwendet wird, die für eine zufällige Anordnung der Strukturelemente sorgt.

Gemäß einem bevorzugten Verfahren zur Herstellung eines Strahlung emittierenden Halbleiterchips gemäß der Erfindung wird eine Maskenschicht auf Teilbereiche des zu strukturierenden Bereichs aufgebracht. Die Maskenschicht bedeckt den zu strukturierenden Bereich nicht vollständig.

Die Maskenschicht kann, beispielsweise mittels Aufdampfen oder Aufsputtern, relativ dünn auf den zu strukturierenden Bereich aufgebracht werden, so dass keine geschlossene Schicht entsteht. Dabei kann die Maskenschicht eine Dicke aufweisen, die kleiner ist als 50nm, insbesondere kleiner als 20nm. Für die Maskenschicht sind Metalle, beispielsweise Ni, Ti oder Pt, dielektrische Materialien, beispielsweise ein Oxid oder Nitrid von Si, Ti oder Zr, oder Polymere, beispielsweise Fotolacke, geeignet. Es kann aber auch eine dickere Schicht als Maskenschicht verwendet werden, die nach dem Aufbringen auf den zu strukturierenden Bereich getempert wird. Hierdurch können Hohlräume beziehungsweise Unterbrechungen ausgebildet werden.

Eine weitere Möglichkeit zur Ausbildung der Maskenschicht besteht darin, die geschlossene Maskenschicht mittels Lithographie zu strukturieren und dadurch Unterbrechungen zu erzeugen.

Darüber hinaus kann die Maskenschicht ein inhomogenes Material enthalten, aus dem nasschemisch Materialbestandteile herausgelöst werden oder welches sich beim nachfolgenden trockenchemischen Ätzen unterschiedlich stark abtragen lässt, so dass infolgedessen die Maskenschicht unregelmäßig angeordnete Unterbrechungen aufweist.

Sobald die Maskenschicht erstellt ist, kann der zu strukturierende Bereich, zum Beispiel eine Halbleiterschicht des Halbleiterchips oder eine dielektrische Schicht des dielektrischen Spiegels, strukturiert werden, indem in den Unterbrechungen der Maskenschicht geätzt wird. Die Strukturelemente bleiben dabei stehen. Insbesondere ist ein anisotropes Ätzverfahren wie etwa trockenchemisches Ätzen geeignet. Die Maskenschicht wird vorzugsweise nach dem Ätzprozess abgelöst. Der strukturierte Bereich weist dann die Strukturelemente auf.

Bei einer anderen Variante zur Herstellung eines Strahlung emittierenden Halbleiterchips gemäß der Erfindung wird ein Maskenmaterial entfernt von dem zu strukturierenden Bereich angeordnet. Während eines Ätzprozesses wird das Maskenmaterial zumindest teilweise abgetragen und lagert sich auf dem zu strukturierenden Bereich ab, wobei der zu strukturierende Bereich gleichzeitig geätzt wird, so dass die Strukturelemente ausgebildet werden.

Beispielsweise kann der Halbleiterchip auf einem Träger angeordnet sein, auf welchem das Maskenmaterial neben dem Halbleiterchip angeordnet ist oder diesen umgibt. Hierbei dient das Maskenmaterial als Target. Während eines Ätzprozesses, der beispielsweise durchgeführt wird, um dem Halbleiterchip die gewünschte Form zu geben, wird das Maskenmaterial zumindest teilweise abgetragen, insbesondere weggeätzt. Das abgetragene Maskenmaterial kann sich auf dem zu strukturierenden Bereich ablagern, wodurch eine Maskenschicht mit Unterbrechungen erzeugt wird. Die Maskenschicht kann sehr dicht angeordnete und feine Strukturen aufweisen. Da der Ätzprozess vorzugsweise während des Ablagerns des Maskenmaterials weitergeführt wird, kann der zu strukturierende Bereich gleichzeitig geätzt werden, so dass die Strukturelemente ausgebildet werden. Vorteilhafterweise können also bei diesem Verfahren das Erzeugen und das Ätzen der Maskenschicht in einem Schritt erfolgen.

Eine andere Möglichkeit, die Maskenschicht in einem Schritt zu erzeugen und zu ätzen, besteht darin, das Maskenmaterial auf einen formgebenden Bereich des Halbleiterchips aufzubringen. Der formgebende Bereich kann beispielsweise bei einem Streifenlaser der Bereich sein, wo der Steg ausgebildet wird. Das Maskenmaterial kann eine geschlossene oder unterbrochene Schicht sein. Bei einer Bearbeitung des formgebenden Bereichs, insbesondere mittels Ätzen, wird das Maskenmaterial zumindest teilweise abgetragen, insbesondere weggeätzt. Das abgetragene Maskenmaterial kann zumindest teilweise auf dem zu strukturierenden Bereich abgelagert werden. Vorzugsweise wird auch bei diesem Verfahren der Ätzprozess während des Ablagerns des Maskenmaterials weitergeführt, so dass der zu strukturierende Bereich geätzt wird und somit die Strukturelemente ausgebildet werden.

Mittels einer geeigneten Wahl der Maskenschicht, der Ätzparameter und des Ätzverfahrens können Form und Größe der Strukturelemente beeinflusst werden.

Weitere Merkmale, Vorteile und Weiterbildungen der Erfindung ergeben sich aus den nachfolgend in Verbindung mit den Figuren 1 bis 10 erläuterten Ausführungsbeispielen.

Es zeigen:
Figur 1 eine schematische Querschnittsansicht eines ersten Ausführungsbeispiels eines Strahlung emittierenden Halbleiterchips gemäß der Erfindung,
Figur 2 eine schematische Querschnittsansicht eines herkömmlichen Strahlung emittierenden Halbleiterchips,
Figur 3 eine schematische Querschnittsansicht eines zweiten Ausführungsbeispiels eines Strahlung emittierenden Halbleiterchips gemäß der Erfindung,
Figur 4 eine schematische Querschnittsansicht eines herkömmlichen Strahlung emittierenden Halbleiterchips,
Figur 5 eine schematische Querschnittsansicht eines dritten Ausführungsbeispiels eines Strahlung emittierenden Halbleiterchips gemäß der Erfindung,
Figur 6 eine schematische Querschnittsansicht eines vierten Ausführungsbeispiels eines Strahlung emittierenden Halbleiterchips gemäß der Erfindung,
Figur 7 eine schematische Querschnittsansicht eines fünften Ausführungsbeispiels eines Strahlung emittierenden Halbleiterchips gemäß der Erfindung,
Figur 8 eine schematische Querschnittsansicht eines sechsten Ausführungsbeispiels eines Strahlung emittierenden Halbleiterchips gemäß der Erfindung,
Figur 9 eine schematische Querschnittsansicht eines siebten Ausführungsbeispiels eines Strahlung emittierenden Halbleiterchips gemäß der Erfindung,
Figuren 10A, 10B und 10C verschiedene Schritte eines Ausführungsbeispiels eines Verfahrens gemäß der Erfindung,

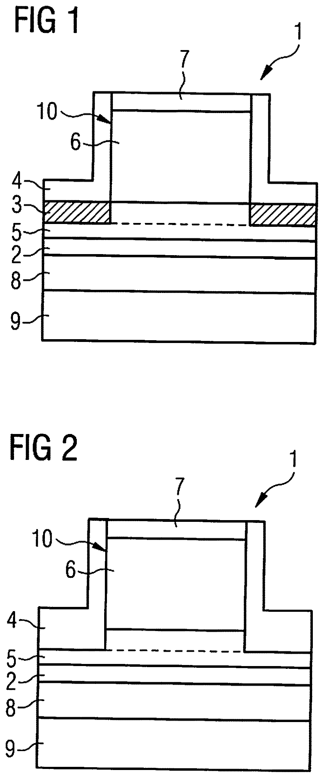

In Figur 1 ist ein Strahlung emittierender Halbleiterchip 1 dargestellt, der ein Laserdiodenchip ist. Insbesondere ist der Laserdiodenchip ein Streifenlaser und weist einen Steg 10 auf. Der Steg 10 erstreckt sich bis zu einer ersten Wellenleiterschicht 5, die der aktiven Zone 2 unmittelbar benachbart ist, und weist damit eine Ätztiefe auf, bei welcher zwar ein relativ kleiner Schwellstrom erzielt werden kann, bei welcher jedoch ohne strukturierte Bereiche 3 höhere Moden auftreten. Ein herkömmlicher Halbleiterchip ohne strukturierte Bereiche ist in Figur 2 dargestellt. Im Gegensatz dazu sind bei dem in Figur 1 gezeigten Halbleiterchip 1 vorteilhafterweise an zwei gegenüber liegenden Flanken des Steges 10 strukturierte Bereiche 3 angeordnet.

Die strukturierten Bereiche 3 weisen Strukturelemente (nicht dargestellt) auf, die unregelmäßig angeordnet sind, eine Breite b ≤ λ und einen Abstand a ≤ λ voneinander aufweisen. Bei größeren Wellenlängen, das heißt bei Strahlung am langwelligen Ende des Lichtspektrums, können die Strukturelemente insbesondere eine Breite b ≤ λ/4 und einen Abstand a ≤ λ/4 voneinander aufweisen. Ferner ist vorzugsweise das Verhältnis g:h ≤ 1:10, insbesondere g:h = 1:10.

Bei diesem Ausführungsbeispiel sind die Strukturelemente aus der ersten Wellenleiterschicht 5 herausgeätzt und enthalten somit das gleiche Material wie die erste Wellenleiterschicht 5. Insbesondere ist das Material ein Halbleitermaterial.

Eine Passivierungsschicht 4, die beispielsweise ein Siliziumoxid enthält, überformt die strukturierten Bereiche 3 und füllt Zwischenräume zwischen den einzelnen Strukturelementen aus. Durch die Verzahnung zwischen den aus der ersten Wellenleiterschicht 5 herausstehenden Strukturelementen mit der Passivierungsschicht 4 haftet die Passivierungsschicht 4 besonders gut auf der Wellenleiterschicht 5. Ferner kann mittels der Strukturelemente beziehungsweise mittels des strukturierten Bereichs 3 der Brechungsindexsprung zwischen der Wellenleiterschicht 5 und der Passivierungsschicht 4 verringert werden. Denn eine gedachte Zwischenschicht, welche die Strukturelemente und die durch die Passivierungsschicht 4 ausgefüllten Zwischenräume umfasst und somit zwischen der Wellenleiterschicht 5 und der Passivierungsschicht 4 angeordnet ist, weist einen effektiven Brechungsindex n_{eff} auf, der zwischen dem ersten Brechungsindex n₁ des Materials der Strukturelemente und dem zweiten Brechungsindex n₂ der Passivierungsschicht 4 liegt.

Die der Wellenleiterschicht 5 benachbarte aktive Zone 2 kann im einfachsten Falle eine p-leitende und eine n-leitende Halbleiterschicht aufweisen, zwischen welchen ein Strahlung erzeugender pn-Übergang angeordnet ist. Die aktive Zone 2 kann jedoch auch eine Doppelheterostruktur, eine Einfach-Quantentopfstruktur oder eine Mehrfach-Quantentopfstruktur (MQW) aufweisen. Die in der aktiven Zone 2 erzeugte Strahlung wird bei diesem Ausführungsbeispiel durch die Kanten des Halbleiterchips 1 emittiert. Die Hauptabstrahlrichtung verläuft parallel zu dem Steg 10, der streifenförmig ausgebildet ist.

Die aktive Zone 2 ist auf einer zweiten Wellenleiterschicht 8 angeordnet. Die erste Wellenleiterschicht 5 und die zweite Wellenleiterschicht 8 weisen verschiedene Leitungstypen auf. Beispielsweise kann die erste Wellenleiterschicht 5 p-leitend und die zweite Wellenleiterschicht 8 n-leitend sein. Die beiden Wellenleiterschichten 5 und 8 werden jeweils auf einer der aktiven Zone 2 abgewandten Seite durch eine Mantelschicht begrenzt. Die erste Mantelschicht 6 weist die gleiche Leitfähigkeit auf wie die erste Wellenleiterschicht 5, auf die sie aufgebracht ist. Die zweite Mantelschicht 9 weist den gleichen Leitungstyp auf wie die zweite Wellenleiterschicht 8, die auf die zweite Mantelschicht 9 aufgebracht ist.

Vorzugsweise sind alle Schichten bis auf die Passivierungsschicht 4 und eine auf dem Steg 10 angeordnete Kontaktschicht 7 epitaktisch aufeinander aufgewachsen und bilden einen Schichtenstapel aus Halbleiterschichten. Das Halbleitermaterial der Halbleiterschichten kann ein auf einem Nitrid-, Phosphid- oder Arsenidverbindungshalbleiter basierendes Material sein.

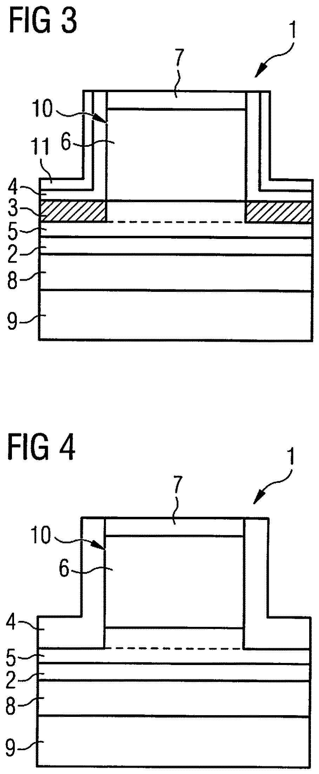

In Figur 3 ist ein Strahlung emittierender Halbleiterchip 1 dargestellt, der einen Aufbau wie der in Figur 1 gezeigte Halbleiterchip 1 und zusätzlich eine Absorberschicht 11 aufweist. Die Absorberschicht 11 ist direkt auf die Passivierungsschicht 4 aufgebracht. Vorteilhafterweise kann mittels der beiden separaten Schichten, von denen die Passivierungsschicht 4 elektrisch isolierend ist und die Absorberschicht 11 höhere Moden dämpft, die elektrische Isolierung unabhängig vom Absorptionsgrad beeinflusst werden. Hingegen ist bei einem herkömmlichen Halbleiterchip 1, wie in Figur 4 dargestellt, eine einzige Schicht für die elektrische Isolierung und zur Modendämpfung vorgesehen, nämlich die absorbierende Passivierungsschicht 4, die eine Mischung aus einem elektrisch isolierenden Material und einem absorbierenden Material enthält. Bei dem Ausführungsbeispiel der Figur 4 muss diese Lösung verfolgt werden, da typischerweise ein relativ starker Brechungsindexsprung zwischen der Wellenleiterschicht 5 und der Passivierungsschicht 4 dazu führt, dass eine optische Welle nicht allzu tief in die Passivierungsschicht 4 eindringen kann. Würde eine separate Absorberschicht verwendet werden, könnte die optische Welle kaum in diese gelangen, was eine schwache Dämpfung höherer Moden zur Folge hätte.

Mittels der strukturierten Bereiche 3 kann der Brechungsindexsprung bei dem Ausführungsbeispiel der Figur 3 verringert werden. Dadurch kann eine optische Welle tiefer in die Schichten eindringen und bis zur Absorberschicht 11 gelangen.

Vorzugsweise enthält die Absorberschicht 11 ein Oxid oder Nitrid, insbesondere ITO oder ein Oxid oder Nitrid von Si, Ti, Al, Ga, Nb, Zr, Ta, Hf, Zn, Mg, Rh, In. Diese Materialien sind bei einem auf Nitrid-Verbindungshalbleitern basierenden Halbleiterchip, wie im Rahmen der vorliegenden Erfindung bevorzugt, besonders geeignet. Für die Passivierungsschicht 4 kann beispielsweise ein Siliziumoxid verwendet werden.

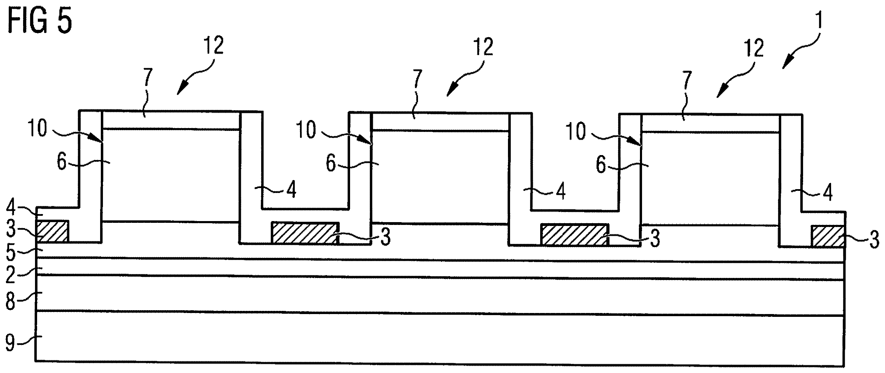

Figur 5 zeigt ein weiteres Ausführungsbeispiel eines Strahlung emittierenden Halbleiterchips 1 gemäß der Erfindung. Der hier dargestellte Halbleiterchip 1 ist ein Laserarray, das mehrere Streifenlaser 12 und mehrere strukturierte Bereiche 3 aufweist, wobei jeweils ein strukturierter Bereich 3 zwischen zwei benachbarten Streifenlasern 12 angeordnet ist. Mittels der strukturierten Bereiche 3 kann ein Übersprechen von Streulicht von dem einen Streifenlaser zum anderen besser unterdrückt werden.

Die Streifenlaser 12 sind keine einzelnen Bauelemente. Vielmehr weist der Halbleiterchip 1 eine durchgehende aktive Zone 2 auf. Lediglich die vorderseitige Kontaktierung der Streifenlaser 12 erfolgt mittels der ersten Kontaktschichten 7 separat.

Bei dem in Figur 5 dargestellten Ausführungsbeispiel sind die Streifenlaser 12 wie der in Figur 1 dargestellte Strahlung emittierende Halbleiterchip 1 aufgebaut. Die Streifenlaser 12 können jedoch auch wie der in Figur 3 dargestellte Strahlung emittierende Halbleiterchip 1 aufgebaut sein.

Wird ein Aufbau ohne Absorberschicht gewählt, so kann mittels der strukturierten Bereiche 3 der Brechungsindexübergang zwischen dem Schichtenstapel und der Umgebung und damit die Wahrscheinlichkeit für Totalreflexionen verringert werden. Dadurch kann Streulicht besser aus dem Halbleiterchip 1 auskoppeln, wodurch ein Übersprechen von einem Streifenlaser zum anderen unterdrückt werden kann. Bei Verwendung einer Absorberschicht auf der Passivierungsschicht 4 kann das Streulicht vorteilhafterweise absorbiert werden.

Die Strukturelemente können eine Breite λ < b ≤ 4µm aufweisen. In diesem Fall wirken die Strukturelemente als Streuzentren. Die Strukturelemente können jedoch auch eine Breite b ≤ λ, bei größeren Wellenlängen auch b ≤ λ/4, aufweisen, so dass die von der Passivierungsschicht 4 umgebenen Strukturelemente eine Zwischenschicht mit einem effektiven Brechungsindex n_{eff} darstellen.

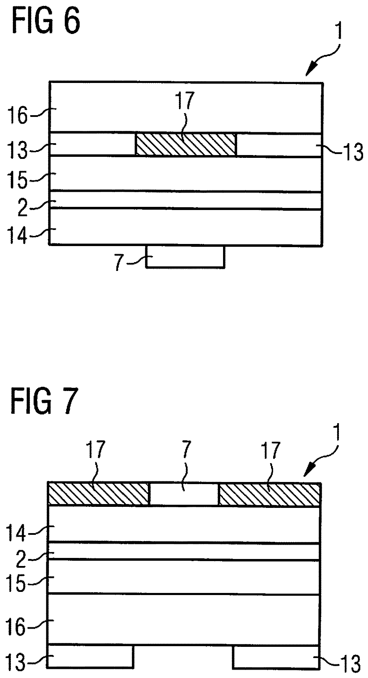

Die Figuren 6 bis 8 zeigen Strahlung emittierende Halbleiterchips 1. Die Strahlung emittierenden Halbleiterchips 1 sind vorzugsweise Leuchtdioden, die im Gegensatz zu den in den Figuren 1 bis 5 dargestellten Laserdioden keine kohärente Strahlung emittieren.

Den Halbleiterchips 1 der Figuren 6 bis 8 ist gemein, dass sie einen dielektrischen Spiegel 17 mit einer ersten dielektrischen Schicht (nicht dargestellt) und einer zweiten dielektrischen Schicht (nicht dargestellt) aufweisen. Der strukturierte Bereich (nicht dargestellt) befindet sich am Übergang zwischen der ersten und der zweiten dielektrischen Schicht.

Figur 6 zeigt einen Halbleiterchip 1, der ein Dünnfilm-Halbleiterchip ist. Der dargestellte Dünnfilm-Halbleiterchip 1 weist einen Schichtenstapel mit epitaktisch gewachsenen Halbleiterschichten 15, 2, 14 auf, von welchem das Aufwachssubstrat abgelöst ist. Die Schicht 14 ist eine erste Schicht mit einem ersten Leitungstyp, die vorzugsweise p-leitend ist, und die Schicht 15 eine zweite Schicht mit einem zweiten Leitungstyp, die vorzugsweise n-leitend ist.

Der Schichtenstapel ist auf dem Träger 16 angeordnet, wobei sich zwischen dem Träger 16 und dem Schichtenstapel der dielektrische Spiegel 17 befindet. Der dielektrische Spiegel 17 erstreckt sich nicht über die gesamte Fläche des Schichtenstapels, sondern ist von einer zweiten Kontaktschicht 13 umgeben, mittels welcher die aktive Zone 2 mit dem elektrisch leitenden Träger 16 elektrisch verbunden ist. Ein weiterer elektrischer Kontakt, die erste Kontaktschicht 7, ist auf einer dem dielektrischen Spiegel 17 abgewandten Seite der aktiven Zone 2 angeordnet. Diese Seite stellt die Auskoppelseite des Halbleiterchips 1 dar.

Mittels des dielektrischen Spiegels 17 kann die Strahlung, die von der aktiven Zone 2 in Richtung des dielektrischen Spiegels 17 ausgesandt wird auf effektive Weise in Richtung der Auskoppelseite reflektiert werden, wie im Folgenden erklärt wird.

Die Strukturelemente mit einer Breite b ≤ λ sind vorzugsweise aus der ersten Schicht des dielektrischen Spiegels 17 gebildet und von der zweiten Schicht des dielektrischen Spiegels 17 umgeben. Mittels der überformten Strukturelemente und der sich daraus ergebenden Zwischenschicht kann eine optische Welle besser in die zweite Schicht eindringen und mit dieser wechselwirken. Die erste Schicht enthält ein erstes Material mit einem ersten Brechungsindex n₁ und die zweite Schicht ein zweites Material mit einem zweiten Brechungsindex n₂. Vorzugsweise weist die zweite Schicht Einschlüsse auf, insbesondere Lufteinschlüsse, mit einem Brechungsindex, der kleiner ist als der zweite Brechungsindex n₂. Dadurch kann der zweite Brechungsindex n₂ und damit der effektive Brechungsindex n_{eff} abgesenkt werden. Dies hat den Vorteil, dass der Grenzwinkel der Totalreflexion verkleinert ist, so dass ein größerer Strahlungsanteil mittels an dem dielektrischen Spiegel 17 auftretender Totalreflexion in Richtung der Auskoppelseite des Strahlung emittierenden Halbleiterchips 1 reflektiert werden kann. Die erste und die zweite Schicht können jeweils ein Oxid, Nitrid oder Oxinitrid von Si, Ti, Al, Ga, Nb, Zr, Ta, Hf, Zn, Mg, Rh, In enthalten.

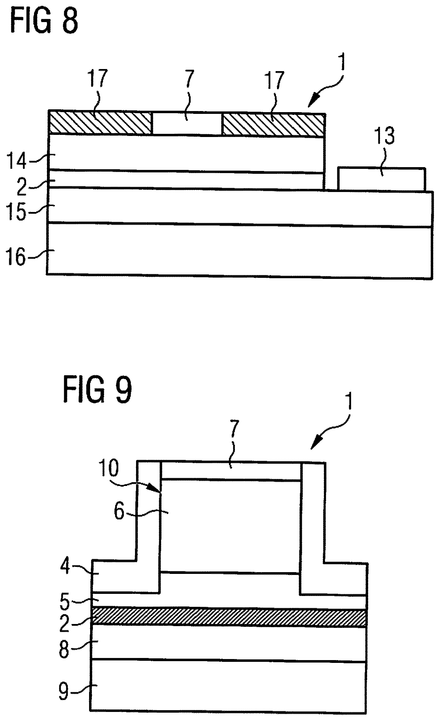

Eine entsprechende Funktionsweise liegt den in den Figuren 7 und 8 dargestellten Strahlung emittierenden Halbleiterchips 1 zugrunde. Beide Halbleiterchips 1 weisen ein transparentes Substrat 16 auf. Somit kann die Strahlungsauskopplung durch das Substrat 16 hindurch erfolgen. Der dielektrische Spiegel 17 ist auf einer dem Substrat 16 und damit auch auf einer der Auskoppelseite gegenüber liegenden Seite des Halbleiterchips 1 angeordnet. Der dielektrische Spiegel 17 bedeckt einen äußeren Bereich des Schichtenstapels. Im inneren Bereich ist die erste Kontaktschicht 7 angeordnet.

Bei dem Halbleiterchip 1 der Figur 7 ist die zweite Kontaktschicht 13 auf dem Substrat 16 aufgebracht. Hingegen weist der Halbleiterchip 1 der Figur 8 die zweite Kontaktschicht 13 auf der zweiten Schicht 15 auf.

Die erste und die zweite Schicht 14 und 15 sowie die aktive Zone 2 können jeweils aus mehreren Teilschichten bestehen. Dies gilt für alle beschriebenen Ausführungsbeispiele.

Figur 9 zeigt einen Strahlung emittierenden Halbleiterchip 1, der eine Laserdiode ist und vom Aufbau her weitgehend den Streifenlasern der Figuren 1 bis 4 entspricht.

Bei der dargestellten Ausführungsform ist der strukturierte Bereich (nicht bezeichnet) mit Strukturelementen der Breite b ≤ λ in der aktiven Zone 2 angeordnet. Insbesondere bildet der strukturierte Bereich eine Quantentopfstruktur. Mittels des strukturierten Bereichs kann ein verbesserter Einschluss der Ladungsträger in der aktiven Zone 2 erzielt werden.

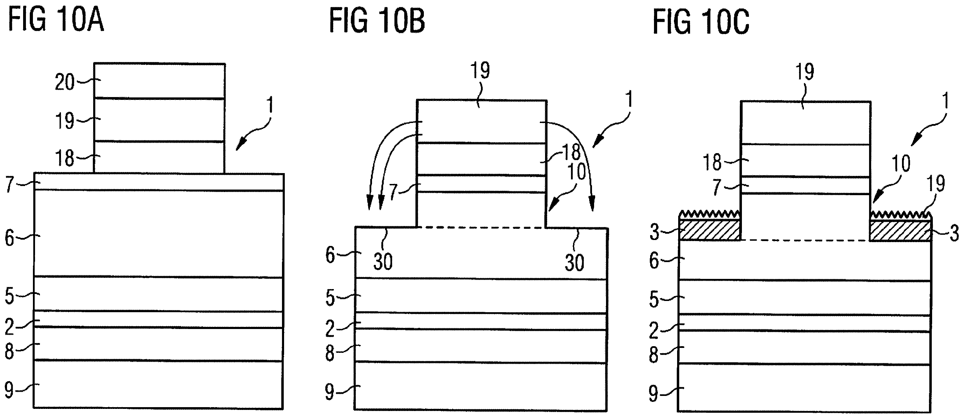

Im Zusammenhang mit den Figuren 10A bis 10C wird nun ein Ausführungsbeispiel eines Verfahrens gemäß der Erfindung beschrieben.

Hierbei wird auf einen Schichtenstapel eines Hableiterchips 1 mit den Schichten 7, 6, 5, 2, 8 und 9, der noch der Formgebung bedarf, eine formgebende Maske 18 aufgebracht (vgl. Figur 10A). Beispielsweise kann die formgebende Maske 18 eine Ätzmaske zur Herstellung eines Steges 10 sein (vgl. Figur 10B).

Auf die formgebende Maske 18 wird ein Maskenmaterial 19 aufgebracht, das zur Herstellung des strukturierten Bereichs 3 (vgl. Figur 10C) vorgesehen ist. Das Maskenmaterial 19 ist hierbei entfernt von zu strukturierenden Bereichen 30 angeordnet. Das Maskenmaterial 19 kann ein Metall, beispielsweise Ni, Ti oder Pt, ein dielektrisches Material, beispielsweise ein Oxid oder Nitrid von Si, Ti oder Zr, oder ein Polymer, beispielsweise einen Fotolack, enthalten. Abschließend kann auf das Maskenmaterial 19 eine Schutzschicht 20 aufgebracht werden.

Zur Herstellung des Steges 10 wird ein Ätzprozess durchgeführt (vgl. Figur 10B). Hierbei werden die erste Kontaktschicht 7 und die erste Wellenleiterschicht 6 derart strukturiert, dass der Steg 10 ausgebildet wird. Bei diesem Vorgang wird die Schutzschicht 20 vollständig weggeätzt. Die Ätztiefe des Steges 10 kann durch weiteres Ätzen vergrößert werden. Dabei wird das Maskenmaterial 19, das zur Herstellung der Strukturelemente dient, zumindest teilweise abgetragen und kann sich auf den zu strukturierenden Bereichen 30 ablagern (vgl. Figur 10B).

Da der Ätzprozess weitergeführt wird, findet zugleich eine Strukturierung der Bereiche 30 statt, so dass die strukturierten Bereiche 3 mit Strukturelementen ausgebildet werden (vgl. Figur 10C). Die Strukturelemente können an ihrer Spitze auch nach dem Ätzprozess noch Maskenmaterial aufweisen, das nicht notwendigerweise abgelöst werden muss. Das im Zusammenhang mit den Figuren 10A bis 10C beschriebene Verfahren führt zu einer Art selbstorganisierter Herstellung der Strukturelemente, da während des Ätzprozesses ohne gezielte Erzeugung einer Maskenschicht die Strukturelemente ausgebildet werden.

## Patentansprüche

1. Strahlung emittierender Halbleiterchip (1) mit
- einer aktiven Zone (2) zur Erzeugung von Strahlung der Wellenlänge λ,
- einem strukturierten Bereich (3) mit unregelmäßig angeordneten Strukturelementen, die ein erstes Material mit einem ersten Brechungsindex n₁ enthalten und die von einem Medium umgeben sind, das ein zweites Material mit einem zweiten Brechungsindex n₂ aufweist, wobei
- die Dicke einer Zwischenschicht, welche die Strukturelemente und das Medium aufweist, einer maximalen Höhe der Strukturelemente entspricht, wobei für einen effektiven Brechungsindex neff der Zwischenschicht n2 < neff < n1 gilt,
- der Halbleiterchip (1) ein Streifenlaser mit einem Steg (10) ist, wobei der strukturierte Bereich (3) zur Auskopplung von Streulicht neben dem Steg (10) angeordnet ist, **dadurch gekennzeichnet, dass**
- eine Grundflächenbreite g der jeweiligen Strukturelemente kleiner ist als eine Höhe h der jeweiligen Strukturelemente, und
- das Medium eine die Strukturelemente bedeckende Passivierungsschicht (4) oder Absorberschicht (11) ist.

2. Strahlung emittierender Halbleiterchip (1) nach Anspruch 1, wobei
die Strukturelemente jeweils eine Breite b ≤ 4µm und einen Abstand a ≤ 4µm voneinander aufweisen.

3. Strahlung emittierender Halbleiterchip (1) nach Anspruch 1, wobei
die Strukturelemente jeweils eine Breite b ≤ λ und einen Abstand a ≤ λ voneinander aufweisen.

4. Strahlung emittierender Halbleiterchip (1) nach Anspruch 1, wobei
der effektive Brechungsindex n_{eff} durch die Konzentration des ersten Materials relativ zu der Konzentration des zweiten Materials in der Zwischenschicht eingestellt ist.

5. Strahlung emittierender Halbleiterchip (1) nach einem der vorhergehenden Ansprüche, wobei der strukturierte Bereich (3) an den Flanken des Steges (10) angeordnet ist.

6. Strahlung emittierender Halbleiterchip (1) nach Anspruch 5, wobei die Strukturelemente aus einer Halbleiterschicht des Halbleiterchips (1) gebildet sind.

7. Strahlung emittierender Halbleiterchip (1) nach einem der Ansprüche 1 oder 3 bis 4, der einen dielektrischen Spiegel (17) aufweist, wobei die Strukturelemente aus einer ersten Schicht des dielektrischen Spiegels (17) gebildet und von einer zweiten Schicht des dielektrischen Spiegels (17) umgeben sind.

8. Strahlung emittierender Halbleiterchip (1) nach einem der Ansprüche 1 bis 3, wobei die aktive Zone (2) den strukturierten Bereich (2) aufweist, der eine Quantentopfstruktur bildet.

9. Strahlung emittierender Halbleiterchip (1) nach Anspruch 1,
der eine Leuchtdiode ist, wobei der strukturierte Bereich (3) eine Auskoppelschicht der Leuchtdiode ist.

10. Verfahren zur Herstellung eines Halbleiterchips (1) nach einem der vorhergehenden Ansprüche, wobei eine Maskenschicht mit Unterbrechungen auf den zu strukturierenden Bereich (30) aufgebracht wird und der Bereich (30) in den Unterbrechungen geätzt wird, so dass nach Ablösen der Maskenschicht der strukturierte Bereich (3) mit den Strukturelementen ausgebildet ist.

11. Verfahren zur Herstellung eines Halbleiterchips (1) nach einem der Ansprüche 1 bis 9, wobei ein Maskenmaterial (19) entfernt von einem zu strukturierenden Bereich (30) angeordnet wird, während eines Ätzprozesses zumindest teilweise abgetragen wird und sich auf dem zu strukturierenden Bereich (30) ablagert, wobei der zu strukturierende Bereich (30) gleichzeitig geätzt wird, so dass die Strukturelemente ausgebildet werden.

## Claims

1. Radiation-emitting semiconductor chip (1) having
- an active zone (2) for generating radiation having a wavelength λ,
- a structured region (3) having irregularly arranged structural elements comprising a first material having a first refractive index n₁ and being surrounded by a medium comprising a second material having a second refractive index n₂, wherein
- the thickness of an intermediate layer comprising the structural elements and the medium corresponds to a maximum height of the structural elements, wherein for an effective refractive index neff of the intermediate layer equates n2 < neff < n1,
- the semiconductor chip (1) is a stripe laser having a ridge (10), wherein the structured region (3) for coupling out scattered light is arranged next to the ridge (10), **characterized in that**
- a base width g of the respective structural elements is smaller than a height h of the respective structural elements, and
- the medium is a passivation layer (4) or an absorber layer (11) covering the structural elements.

2. Radiation-emitting semiconductor chip (1) according to claim 1, wherein
the structural elements each have a width b ≤ 4µm and a distance a ≤ 4µm from one another.

3. Radiation-emitting semiconductor chip (1) according to claim 1, wherein
the structural elements each have a width b ≤ λ and a distance a ≤ λ from one another.

4. Radiation-emitting semiconductor chip (1) according to claim 1, wherein
the effective refractive index n_{eff} is set by the concentration of the first material relative to the concentration of the second material in the interlayer.

5. Radiation-emitting semiconductor chip (1) according to one of the preceding claims, wherein the structured region (3) is arranged at the flanks of the ridge (10).

6. Radiation-emitting semiconductor chip (1) according to claim 5, wherein the structural elements are formed from a semiconductor layer of the semiconductor chip (1).

7. Radiation-emitting semiconductor chip (1) according to one of claims 1 or 3 to 4, comprising a dielectric mirror (17), wherein the structural elements are formed of a first layer of the dielectric mirror (17) and are surrounded by a second layer of the dielectric mirror (17).

8. Radiation-emitting semiconductor chip (1) according to one of claims 1 to 3, wherein the active region (2) comprises the structured region (2) forming a quantum well structure.

9. Radiation-emitting semiconductor chip (1) according to claim 1,
which is a light-emitting diode, wherein the structured region (3) is a coupling out layer of the light-emitting diode.

10. Method for producing a semiconductor chip (1) according to one of the preceding claims, wherein a mask layer with interruptions is applied to the region (30) to be structured and the region (30) is etched in the interruptions , such that the structured region (3) having the structure elements is formed after the mask layer has been stripped away.

11. Method for producing a semiconductor chip (1) according to one of claims 1 to 9, wherein a mask material (19) is arranged remotely from a region (30) to be structured, is at least partially removed during an etching process and is deposited on the region (30) to be structured, wherein the region (30) to be structured is simultaneously etched, such that the structural elements are formed.

## Revendications

1. Puce semi-conductrice (1) émettant un rayonnement comportant
- une zone active (2) pour générer un rayonnement de longueur d'onde λ,
- une région structurée (3) comportant des éléments structuraux disposés de manière irrégulière, comprenant un premier matériau ayant un premier indice de réfraction n₁ et sont entourée d'un milieu qui comporte un deuxième matériau ayant un deuxième indice de réfraction n₂, dans laquelle
- l'épaisseur d'une couche intermédiaire comprenant les éléments structuraux et le milieu correspond à une hauteur maximale des éléments structuraux, dans laquelle, pour un indice de réfraction effectif neff de la couche intermédiaire n2 < neff < n1 s'applique
- la puce semi-conductrice (1) est un laser à bande ayant une barre (10), dans laquelle la région structurée (3) pour le découplage de la lumière diffusée étant disposée à côté de l'barre (10), **caractérisé en ce que**
- une largeur de base g des éléments structuraux respectifs est inférieure à une hauteur h des éléments structuraux respectifs, et
- le milieu est une couche de passivation (4) ou une couche absorbante (11) recouvrant les éléments structuraux.

2. Puce semi-conductrice (1) émettant un rayonnement selon la revendication 1, dans laquelle
les éléments structuraux présentent respectivement une largeur b ≤ 4µm et une distance a ≤ 4µm les uns par rapport aux autres.

3. Puce semi-conductrice (1) émettant un rayonnement selon la revendication 1, dans laquelle
les éléments structuraux ont respectivement une largeur b ≤ λ et une distance a ≤ λ les uns par rapport aux autres.

4. Puce semi-conductrice (1) émettant un rayonnement selon la revendication 1, dans laquelle
l'indice de réfraction effectif neff est fixé par la concentration du premier matériau par rapport à la concentration du deuxième matériau dans la couche intermédiaire.

5. Puce semi-conductrice (1) émettant un rayonnement selon l'une quelconque des revendications précédentes, dans laquelle la région structurée (3) est disposée sur les flancs de la barre (10).

6. Puce semi-conductrice (1) émettant un rayonnement selon la revendication 5, dans laquelle les éléments structuraux sont formés d'une couche semi-conductrice de la puce semi-conductrice (1).

7. Puce semi-conductrice (1) émettant un rayonnement selon l'une quelconque des revendications 1 ou 3 à 4, comprenant un miroir diélectrique (17), dans laquelle les éléments structuraux sont formés d'une première couche du miroir diélectrique (17) et entourés d'une deuxième couche du miroir diélectrique (17).

8. Puce semi-conductrice (1) émettant un rayonnement selon l'une quelconque des revendications 1 à 3, dans laquelle la zone active (2) comprend la région structurée (2) formant une structure de puits quantique.

9. Puce semi-conductrice (1) émettant un rayonnement selon la revendication 1,
qui est une diode électroluminescente, dans lequel la région structurée (3) est une couche de découplage de la diode électroluminescente.

10. Procédé de fabrication d'une puce semi-conductrice (1) selon l'une quelconque des revendications précédentes, dans lequel une couche de masque avec des interruptions est appliquée sur la région (30) devant être structurée et la région (30) est gravée dans les interruptions, de sorte qu'après décollement de la couche de masque, la région structurée (3) est formée avec les éléments structuraux.

11. Procédé de fabrication d'une puce semi-conductrice (1) selon l'une quelconque des revendications 1 à 9, dans lequel un matériau de masque (19) est disposé à distance d'une région (30) devant être structurée, est au moins partiellement éliminé lors d'un processus de gravure et est déposé sur la région (30) devant être structurée, la région (30) devant être structurée étant simultanément gravée de sorte que les éléments structuraux sont formés.
